# Europäisches Patentamt
# European Patent Office
# Office européen des brevets

(11) Veröffentlichungsnummer: **0 219 074**
**B1**

(12) **EUROPÄISCHE PATENTSCHRIFT**

(45) Veröffentlichungstag der Patentschrift:
29.08.90

(21) Anmeldenummer: 86114056.4

(22) Anmeldetag: 10.10.86

(51) Int. Cl.⁵: **H03K 17/945**, H03K 17/22, H03K 17/08

(54) Zweidraht-Schalter mit einem Leistungstransistor.

(30) Priorität: 17.10.85 DE 3536925

(43) Veröffentlichungstag der Anmeldung:
22.04.87 Patentblatt 87/17

(45) Bekanntmachung des Hinweises auf die Patenterteilung:
29.08.90 Patentblatt 90/35

(84) Benannte Vertragsstaaten:
CH LI

(56) Entgegenhaltungen:
WO-A-83/04458
DE-A- 3 320 975
DE-B- 2 435 501
DE-B- 2 545 919
DE-C- 3 146 709
US-A- 4 138 709

(73) Patentinhaber: Gebhard Balluff Fabrik feinmechanischer Erzeugnisse GmbH & Co., Gartenstrasse 21, D-7303 Neuhausen a.d.F.(DE)

(72) Erfinder: Kammerer, Heinz, Achalmstrasse 29, D-7302 Ostfildern 2(DE)
Erfinder: Dolderer, Peter, Krebenwiesenweg 9, D-7300 Esslingen(DE)

(74) Vertreter: Hoeger, Stellrecht & Partner, Uhlandstrasse 14 c, D-7000 Stuttgart 1(DE)

ACTORUM AG

**Beschreibung**

Die Erfindung betrifft einen Zweidraht-Schalter mit einem Leistungstransistor, insbesondere einem V-MOS-Transistor, welcher in Serie mit einer Hilfsimpedanz zwischen zwei Schalteranschlußleitungen liegt, die mit den Polen einer Gleichspannungsquelle zur Erzeugung einer zwischen Null und einem Maximalwert pulsierenden Gleichspannung verbindbar sind, mit einem, insbesondere berührungslos, von außen beeinflußbaren Initiator zur Erzeugung von Sperr- und Durchsteuersignalen für den Transistor und mit einer Hilfsspannungsquelle zur Erzeugung einer mit dem Takt der pulsierenden Gleichspannung pulsierenden Hilfsspannung.

Ein derartiger Zweidraht-Schalter ist aus der DE-OS 33 20 975 bekannt. Bei dem bekannten Zweidraht-Schalter ist als Hilfsimpedanz insbesondere eine in Serie zu dem Leistungstransistor geschaltete Diode vorgesehen, der ein Kondensator parallel geschaltet ist, welcher als Puffer-Kondensator zur Erzeugung einer Eingangsspannung für einen DC/DC-Wandler dient.

Aus der über der Diode bei durchgeschaltetem Leistungstransistor abfallenden Spannung wird mit Hilfe des DC/DC-Wandlers durch induktive oder kapazitive Spannungsvervielfachung eine Hilfsspannung gewonnen, die als Speisespannung für den Oszillator des Initiators, als Speisespannung für einen Verstärker und gegebenenfalls als Steuerspannung für den Leistungstransistor verwendet werden kann.

Bei der bekannten Lösung ist es ggf. problematisch, daß zur Erzeugung der Hilfsspannung ein erhöhter Spannungsabfall über der Schaltstrecke in Kauf genommen werden muß, insbesondere, wenn es sich bei dem Leistungstransistor um einen V-MOS-Transistor handelt, der eine hohe Steuerspannung benötigt, wobei zu berücksichtigen ist, daß die Spannung über der Diode zwar wegen der Spannungsvervielfachung im Wandler kleiner sein kann als die letztlich benötigten Hilfs- und Steuerspannungen, andererseits jedoch ausreichend hoch sein muß, damit auf der Ausgangsseite des Wandlers nicht nur eine ausreichend hohe Spannung, sondern insgesamt eine ausreichend hohe Energie zur Verfügung steht.

Ausgehend von diesem Stand der Technik liegt der Erfindung die Aufgabe zugrunde, einen Zweidraht-Schalter der eingangs angegebenen Art dahingehend zu verbessern, daß der Spannungsabfall im Lastkreis des Schalters auf ein Minimum reduziert werden kann.

Diese Aufgabe wird gemäß der Erfindung dadurch gelöst, daß eine logische Schaltung vorgesehen ist, die einen nach einer ODER-Funktion arbeitenden, einen ersten Eingang und einen zweiten Eingang aufweisenden Schaltungsteil und einen nach einer UND-Funktion arbeitenden, zwei Eingänge aufweisenden Schaltungsteil aufweist, dessen einer Eingang mit dem Ausgang des ersten Schaltungsteils verbunden ist, und dessen anderer Eingang einen dritten Eingang der logischen Schaltung bildet, daß der erste Eingang mit dem Ausgang der Hilfsspannungsquelle verbunden ist, daß der zweite Eingang mit einem gemeinsamen Verbindungspunkt von Leistungstransistor und Hilfsimpedanz verbunden ist und daß der dritte Eingang mit dem Ausgang des Initiators verbunden ist, und daß die logische Schaltung derart ausgebildet ist, daß der Leistungstransistor durch ein Sperrsignal des Initiators jederzeit sperrbar ist und durch ein Durchsteuersignal des Initiators dann für den Rest des laufenden Impulses der pulsierenden Gleichspannung durchsteuerbar ist, wenn die Spannung am ersten oder zweiten Eingang (a bzw. b) der logischen Schaltung (38) einen einer logischen "1" entsprechenden Schwellwert übersteigt.

Der erfindungsgemäße Transistor-Zweidraht-Schalter arbeitet also mit einer Art Phasenanschnittsteuerung, so daß für die Hilfsspannungsquelle, ähnlich wie bei einem Thyristor-Zweidraht-Schalter mit Phasenanschittsteuerung wie er z. B. aus WO-A 8 304 458 bekannt ist, auch dann für die Dauer des Phasenanschnitts eine hohe Eingangsspannung zur Verfügung steht, wenn der Initiator ein Durchsteuersignal liefert, durch welches der Leistungstransistor bei der bekannten Schaltung leitend gesteuert wird, so daß nur noch eine geringe Restspannung vorhanden ist, die gegebenenfalls höher gehalten wird als dies normalerweise erforderlich wäre, um auf der Eingangsseite der Hilfsspannungsquelle eine ausreichende Energie zur Verfügung zu haben.

Gemäß der Erfindung ergeben sich also hinsichtlich der Hilfsspannungserzeugung ähnliche Vorteile wie bei einem Thyristor-Zweidraht-Schalter, während hinsichtlich der Möglichkeit eines schnellen Sperrens des Lastkreises die besonderen Vorteile eines Transistor-Zweidraht-Schalters voll erhalten bleiben, so daß ein zuverlässiger Kurzschlußschutz erreicht werden kann.

Die Hilfsspannungsquelle zur Erzeugung der Spannung am ersten Eingang der logischen Schaltung kann im einfachsten Fall ein Spannungsteiler zwischen den Schalteranschlußleitungen sein, mit dessen Abgriff der erste Eingang der logischen Schaltung verbunden ist. In diesem Fall ist dann für die Spannungsversorgung des Initiators und gegebenenfalls der Schaltkreise der logischen Schaltung eine eigene Versorgungsschaltung erforderlich, die vorzugsweise als Spannungsregler mit einem Speicherglied ausgebildet ist. Der erste Anschluß der logischen Schaltung kann aber auch direkt mit dem Ausgang eines solchen Spannungsreglers verbunden werden.

Als besonders günstig hat es sich erwiesen, wenn die Hilfsspannungsquelle gemäß Patenanspruch 4 ausgebildet ist, da bei dieser Ausgestaltung zusätzlich zu der normalen Versorgungsspannung eine erhöhte Spannung zur Verfügung steht, die als Steuerspannung für einen V-MOS-Leistungstransistor geeignet ist, für dessen Ansteuerung eine höhere Spannung benötigt wird als beispielsweise für die Versorgung des Initiators. Die erhöhte Spannung, die zunächst nur während des Phasenanschnitts verfügbar ist, kann dabei zum Aufladen eines Kondensators verwendet werden, der bei durchgeschaltetem Transistor die erforderliche Steuerspannung liefert.

Als günstig hat es sich erwiesen, wenn der eingangsseitige Transistor der Hilfsspannungsquelle ein V-MOS-Transistor ist, da in diesem Fall für die Hilfsspannungsquelle nur eine geringe Ansteuerleistung erforderlich ist, und wenn ferner der weitere Transistor ein Darlington-Transistor ist, welcher während des Phasenanschnitts einen ausreichend hohen Strom zum Aufladen des Kondensators am Ausgang der Hilfsspannungsquelle liefert.

Als vorteilhaft hat es sich ferner erwiesen, wenn bei der Ausgestaltung der Hilfsspannungsquelle gemäß den Patentansprüchen 4 oder 5 jeweils in Serie zu den Schaltstrecken der beiden Transistoren Leuchtdioden liegen, die gemäß Patentanspruch 6 zur Anzeige der Auslösung einer Kurzschlußschutzschaltung bzw. zur Funktionsanzeige und zur Betriebsspannungsanzeige dienen können. In Ausgestaltung der Erfindung hat es sich ferner als vorteilhaft erwiesen, wenn eine Schaltung zur Einschaltimpulsunterdrückung vorgesehen ist, durch die für eine vorzugsweise einstellbare Verzögerungszeit nach Einschalten der Gleichspannungsquelle ein Sperrsignal erzeugbar ist, durch welches der Leistungstransistor sperrbar ist, wobei diese Schaltung vorzugsweise gemäß den Patentansprüchen 8 bis 11 ausgestaltet bzw. eingesetzt wird.

Als vorteilhaft hat es sich auch erwiesen, wenn eine Kurzschluß- und Überlastschutzschaltung vorgesehen ist, durch die zumindest für die Dauer einer Kurzschluß- bzw. Überlastbedingung ein Sperrsignal erzeugbar ist, durch welches der Leistungstransistor sperrbar ist und durch welches gegebenenfalls weitere Schaltkreise, insbesondere die Hilfsspannungsquelle, sperrbar sind. Dabei bietet die Verwendung eines Leistungstransistors im Lastkreis den besonderen Vorteil, daß bei einem Kurzschluß auch während des laufenden Impulses der pulsierenden Gleichspannung eine praktisch verzögerungsfreie Sperrung des Lastkreises ermöglicht wird.

Die Kurzschluß- und Überlastschutzschaltung ist gemäß Patentanspruch 13 vorzugsweise so ausgebildet, daß sie im Kurzschlußfall verzögerungsfrei eine Sperrung des Leistungstransistors bewirkt, während bei einer Überlast bzw. einem Überstrom nur dann eine - verzögerte - Abschaltung des Leistungstransistors erfolgt, wenn die Überlastung für ein Zeitintervall andauert, welches größer ist als das durch das Zeitglied vorgegebene Zeitintervall.

Als günstig hat es sich auch erwiesen, wenn als Ausgangskreis der Schutzschaltung eine Speicherschaltung vorgesehen ist, welche solange ein Sperrsignal erzeugt, bis der Schalter nach Behebung der Kurzschluß- bzw. Überlastbedingung extern auf den betriebsbereiten Zustand zurückgesetzt wird.

Ferner hat es sich als vorteilhaft erwiesen, wenn mit dem Ausgang der Speicherschaltung ein astabiler Multivibrator verbunden ist, durch dessen Ausgangssignale eine Leuchtdiode zur Erzeugung periodischer Blinksignale ansteuerbar ist, und zwar insbesondere die Leuchtdiode im Eingangskreis der Hilfsspannungsquelle. Durch eine solche blinkende Leuchtdiode wird nämlich der Störfall für das Bedienungspersonal besonders auffällig signalisiert.

Als besonders vorteilhaft hat sich auch die Ausgestaltung der Schutzschaltung gemäß Patentanspruch 16 erwiesen, da mit Hilfe des niederohmigen Messwiderstandes im Lastkreis problemlos eine ausreichende Spannungsdifferenz für den als Schalter dienenden Transistor erzeugbar ist, während die im Lastkreis dienende Diode auf Stromänderungen bei höheren Strömen kaum noch mit einer auswertbaren Spannungsänderung zwischen ihren Anschlüssen reagiert.

Als besonders vorteilhaft hat es sich in Ausgestaltung der Erfindung erwiesen, wenn gemäß Patentanspruch 17 parallel zu der Diode, über der der Spannungsabfall für die Ansteuerung des zweiten Eingangs der logischen Schaltung ermittelt wird, ein ohmscher Widerstand vorgesehen ist, über dem die Spannung bei absinkendem Strom gegen Ende eines Impulses der pulsierenden Gleichspannung früher abfällt als über der Diode, so daß rechtzeitig eine Sperrung des Leistungstransistors erfolgen kann, um ein vollständiges Sperren desselben am Ende jedes Gleichspannungsimpulses zu erreichen.

Als vorteilhaft hat es sich ferner erwiesen, wenn die ODER-Funktion der logischen Schaltung gemäß Anspruch 18 unter Verwendung von zwei Operationsverstärkern realisiert wird, da diese weitgehend driftfrei arbeiten, so daß die Dauer des Phasenanschnitts nicht in Abhängigkeit von Temperaturänderungen oder dergleichen schwankt.

Außerdem hat es sich als günstig erwiesen, wenn am Ausgang der Phasenanschnittsteuerung eine Triggerschaltung vorgesehen ist, dei bei Eintreten der Schaltbedingung eine steile Impulsflanke liefert und damit ebenfalls zum Einhalten eines exakt vorgebbaren Phasenanschnittwinkels beiträgt. Diese Triggerschaltung kann gegebenenfalls je nach den schaltungstechnischen Erfordernissen einen negierten Ausgang haben, wobei an dieser Stelle anzumerken ist, daß bei einem Zweidraht-Schalter gemäß der Erfindung auch an anderen Stellen der Schaltung unter Umständen eine Invertierung der Signale zweckmäßig ist, um letztlich die gewünschte logische Verknüpfung für das Ein- und Ausschalten des Leistungstransistors im Lastkreis zu erreichen.

Weitere Einzelheiten und Vorteile der Erfindung werden nachstehend anhand von Zeichnungen noch näher erläutert. Es zeigen:

Fig. 1 ein Prinzip-Schaltbild eines Zweidraht-Schalters gemäß der Erfindung;

Fig. 2 ein Blockschaltbild einer bevorzugten Ausführungsform eines Zweidraht-Schalters gemäß der Erfindung;

Fig. 3 bis Fig. 7 Detailschaltbilder der einzelnen Schaltblöcke des Zweidraht-Schalters gemäß Fig. 2; und

Fig. 8 ein vollständiges Schaltbild des Zweidraht-Schalters gemäß Fig. 2, wobei auch der Initiator detailliert dargestellt ist.

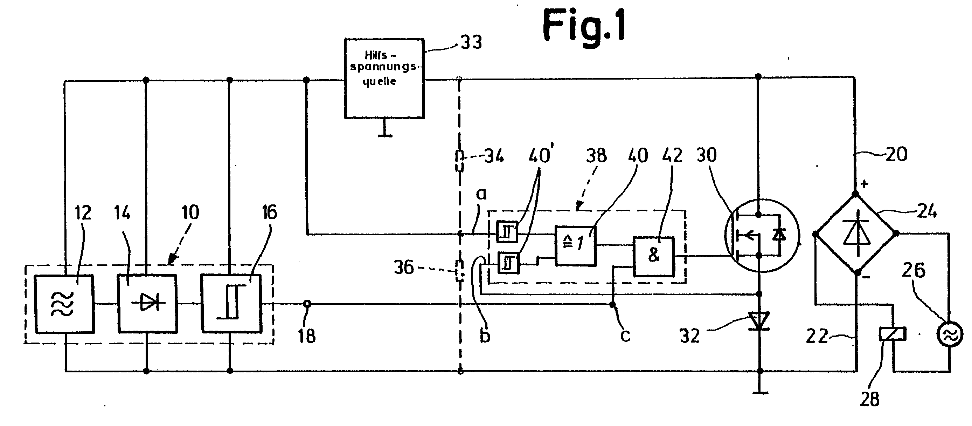

Im einzelnen zeigt Fig. 1 einen Initiator 10, und zwar einen berührungslosen Näherungsinitiator mit einem Oszillator 12, einem Demodulator bzw.

Gleichrichter 14 und einer Triggerstufe 16, deren Ausgang 18 den Ausgang des Initiators 10 bildet.

Der Initiator 10 ist Bestandteil eines Zweidraht-Schalters mit zwei Schalteranschlußleitungen 20, 22, die mit den Polen einer Gleichspannungsquelle, nämlich mit dem positiven Anschluß (+) und dem negativen Anschluß (-) einer Vollweg-Gleichrichterbrücke 24 verbunden sind. Eingangsseitig ist die Brücke an den einen Pol einer Wechselspannungsquelle 26 angeschlossen, deren anderer Pol über eine als Relais dargestellte Last 28 mit dem anderen Eingangsanschluß der Brücke 24 verbunden ist. Zwischen den Schalteranschlußleitungen 20,22 liegt eine Hilfsspannungsquelle 33, die auch als Spannungsregler bzw. Stromversorgung bezeichnet werden könnte und dazu dient, die einzelnen Schaltkreise 12 bis 16 des Initiators 10 auch dann mit einem Betriebsstrom bzw. einer Betriebsspannung zu versorgen, wenn bei durchgeschaltetem Transistor 30 zwischen den Anschlußleitungen 20, 22 praktisch keine Spannung mehr verfügbar ist bzw. nur noch eine geringe Restspannung. Derartige Hilfsspannungsquellen sind beispielsweise bei Thyristor-Zweidraht-Schaltern bekannt, bei denen sich beim Durchschalten des Thyristors dasselbe Problem ergibt, und erzeugen an ihrem Ausgang eine Hilfsspannung U, welche sich mit dem Takt der pulsierenden Gleichspannung am Ausgang der Gleichrichterbrücke 24 ändert, und zwar in der Weise, daß die Hilfsspannung U während des Phasenanschnitts zunächst relativ schnell ansteigt und dann nach Durchschalten der Steuerstrecke, in der bei der erfindungsgemäßen Schaltung der Transistor 30 liegt, bis zum Auftreten der nächsten Nullstelle der pulsierenden Gleichspannung relativ langsam absinkt.

Gemäß der Erfindung ist der Ausgang der Hilfsspannungsquelle 33 mit einem ersten Eingang a einer logischen Schaltung 38 verbunden, die aus einem ODER-Gatter und einem UND-Gatter 42 aufgebaut ist, wobei die beiden Gatter 40, 42 jeweils zwei Eingänge haben. Die beiden Eingänge des ODER-Gatters 40 bilden dabei einen ersten Eingang a und einen zweiten Eingang b der logischen Schaltung, wobei in die betreffenden Eingangsleitungen, wie dies in Fig. 1 der Zeichnung angedeutet ist, Schwellwertschalter bzw. Triggerstufen 40' eingefügt sein können, um klar definierte Eingangssignale für das ODER-Gatter 40 zu erhalten, wobei die angestrebte ODER-Funktion aber auch durch entsprechende interne Ausgestaltung des ODER-Gatters selbst erreicht werden kann. Der Ausgang des ODER-Gatters 40 ist mit dem einen Eingang des UND-Gatters 42 verbunden, dessen anderer Eingang c mit dem Ausgang 18 des Initiators 10 verbunden ist. Der Ausgang des UND-Gatters 42 ist mit der Steuerelektrode (gate) des Transistors 30 verbunden. Der Transistor 30 wird dann durchgesteuert bzw. leitend gesteuert, wenn am Ausgang des UND-Gatters 42 ein einer logischen "1" entsprechendes Signal auftritt, wobei es sich versteht, daß das UND-Gatter 42 so ausgelegt werden muß, daß diese logische "1" einem Signal entspricht, dessen Spannung ausreicht, um den betreffenden Transistor 30 leitend zu steuern, wobei im Falle von V-MOS-Transistoren je nach verwendetem Typ eine Steuerspannung von etwa 2 bis 3 oder auch von etwa 8 bis 12 Volt benötigt wird.

Wie aus der vorstehenden Erläuterung des erfindungsgemäßen Zweidraht-Schalters gemäß Fig. 1 deutlich wird, kann der Transistor 30 durch ein einer logischen "0" entsprechendes Signal vom Ausgang 18 des Initiators 10 jederzeit gesperrt werden, da ein derartiges "0"-Signal am dritten Eingang c der logischen Schaltung 38 zwangsläufig zu einer "0" am Ausgang des UND-Gatters 42 führt, was bedeutet, daß an der Steuerelektrode des Transistors 30 keine Spannung mehr zur Verfügung steht, die den Transistor 30 in den leitenden Zustand bringen oder ihn in diesem Zustand halten könnte.

Wenn am Ausgang 18 des Initiators 10 dagegen ein einer logischen "1" entsprechendes Durchsteuersignal anliegt, dann erhält man am Ausgang des UND-Gatters 42 dann eine logische "1", die ein Durchsteuern des Transistors 30 bewirkt, wenn am Ausgang des ODER-Gatters 40 eine logische "1" vorhanden ist, das heißt wenn an einem der beiden Eingänge a oder b ein Signal ansteht, welches einer logischen "1" entspricht. Letzteres ist bei dem erfindungsgemäßen Zweidraht-Schalter dann der Fall, wenn die Hilfsspannung U am Ausgang der Hilfsspannungsquelle 33, ausgehend von einem zunächst niedrigeren Pegel, zu einem vorgegebenen Zeitpunkt nach dem Beginn eines neuen Impulses der pulsierenden Gleichspannung am Ausgang der Brückenschaltung 24 einen vorgegebenen, der logischen "1" entsprechenden Pegel erreicht, so daß der Transistor 30 bei Vorhandensein eines Durchsteuersignals am Ausgang 18 des Initiators 10 nach einem Nulldurchgang der Wechselspannung auf der Eingangsseite der Brückenschaltung 24 verzögert leitend gesteuert wird; für das Durchsteuern des Transistors 30 wird also eine Art Phasenanschnittsteuerung simuliert, wie sie bei Thyristor-Zweidrahtschaltern bekannt ist, um auch bei durchgeschaltetem Transistor 30 eine ausreichende Speisung der Hilfsspannungsquelle 33 zu gewährleisten, so daß diese ständig die erforderliche Hilfsspannung U liefern kann, welche allerdings, wie oben ausgeführt, keine konstante Spannung ist, sondern eine im Takt der pulsierenden Gleichspannung pulsierende Spannung, die jedoch im eingeschwungenen Zustand der Schaltung niemals auf Null absinkt.

Sobald der Transistor 30 durchgesteuert ist, bricht die Spannung zwischen den Schalteranschlußleitungen 20 und 22 auf eine geringe Restspannung zusammen. Der überwiegende Teil dieser Restspannung steht dabei über der Diode 32 an und damit auch am zweiten Eingang b der logischen Schaltung 38 und bildet dort bei durchgeschaltetem Transistor 30 ein einer logischen "1" entsprechendes Signal für das ODER-Gatter 40, so daß die Einschaltbedingung für den Transistor 30 erhalten bleibt bis der Strom über die Serienschaltung des Transistors 30 mit der Diode 32 aufgrund des Absinkens der pulsierenden Gleichspannung von der Gleichrichterbrücke 24 so weit abgesunken ist, daß die Spannung über der Diode 32 nicht mehr hoch genug ist, um einer logischen "1" zu entsprechen. Der Transistor 30 wird also gegen Ende jedes Impulses der pulsierenden Gleichspannung bzw. gegen Ende der betreffenden Halbwelle des Wechselstroms auf der Eingangsseite der Gleichrichterbrücke 24 gesperrt und bei der nächsten Halbwelle erst wieder verzögert eingeschaltet. Dabei besteht, wie dies in Fig. 1 gestrichelt angedeutet ist, für die Erzeugung der pulsierenden Gleichspannung am Eingang a der logischen Schaltung auch die Möglichkeit, diesen ersten Eingang a der logischen Schaltung 38 mit dem Abgriff eines aus zwei Widerständen 34, 36 gebildeten Spannungsteilers zu verbinden, der parallel zu der Serienschaltung 30, 32 zwischen den Schalteranschlußleitungen 20, 22 liegt. In diesem Fall entfällt natürlich die Verbindung vom Ausgang der Hilfsspannungsquelle 33 zum ersten Eingang a der logischen Schaltung 38. Andererseits ermöglicht die Verwendung eines eigenen Spannungsteilers 34, 36 zur Erzeugung der pulsierenden Hilfsspannung am Eingang a der logischen Schaltung 38 das Arbeiten mit einer Hilfsspannung, die von der erforderlichen Versorgungsspannung für die verschiedenen Baugruppen des Zweidrahtschalters unabhängig ist.

Die Hilfsspannungsquelle 33, welche vorzugsweise als Spannungsregler mit Energiespeicher (Kondensator) ausgebildet ist, erzeugt außer der Hilfs- bzw. Versorgungsspannung U für die Baugruppen 12 bis 16 des Initiators 10 normalerweise auch die Versorgungsspannung für die Gatter 40 und 42 und gegebenenfalls die Triggerstufen 40' der logischen Schaltung 38; in Fig. 1 sind jedoch keine entsprechenden Leitungen eingezeichnet, da im Prinzip passive Gatter 40, 42 ohne besondere Stromversorgung verwendet werden können, die allein mit der Hilfsspannung U am ersten Eingang a bzw. mit der über der Diode 32 abfallenden Spannung am zweiten Eingang b arbeiten.

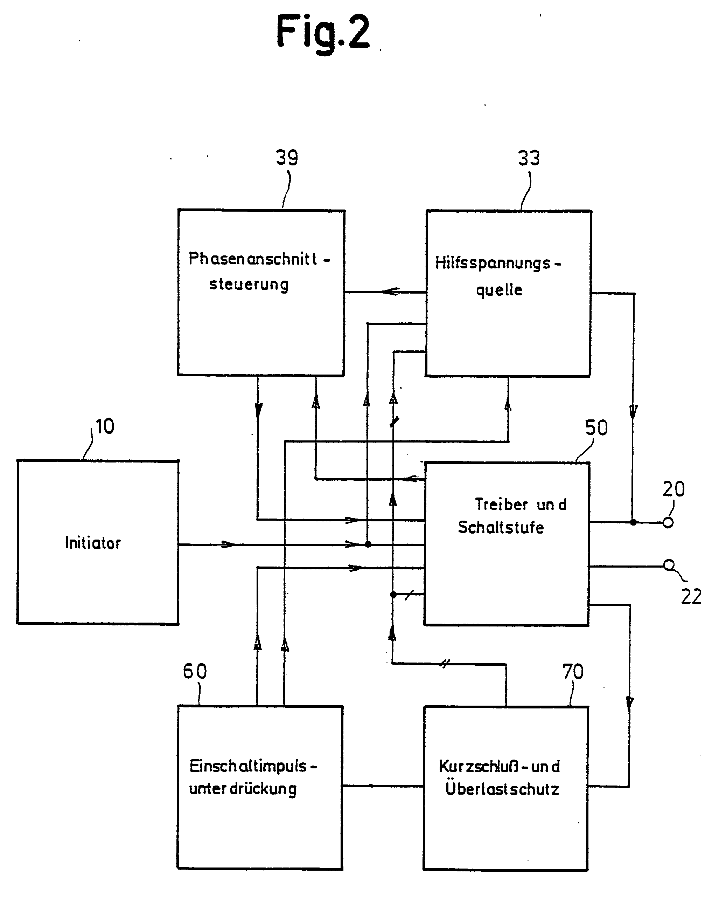

Während vorstehend anhand von Fig. 1 der Zeichnung das Prinzip eines erfindungsgemäßen Transistor-Zweidraht-Schalters mit simulierter Phasenanschnittsteuerung erläutert wurde, soll nachstehend anhand von Fig. 2 bis 8 ein praktisch realisierter Transistor-Zweidraht-Schalter gemäß der Erfindung detailliert erläutert werden.

Im einzelnen zeigt Fig. 2 ein Blockschaltbild dieses Schalters, welcher einen Initiator 10, eine Hilfsspannungsquelle 33, eine Phasenanschnittsteuerung 39, eine Treiber- und Schaltstufe 50, einen Schaltkreis 60 zur Einschaltimpulsunterdrückung und eine Kurzschluß- und Überlastschutzschaltung 70 umfaßt. In dem Blockschaltbild gemäß Fig. 2 sind die einzelnen Schaltungsblöcke über Signalleitungen miteinander verbunden, wobei die Anzahl der Adern bei mehradrigen Signalleitungen in üblicher Weise durch entsprechende Querstriche angedeutet ist und wobei die Wirkungsrichtung der Signale jeweils durch einen Pfeil bzw. einen Doppelpfeil angedeutet ist. Zusätzlich ist anzumerken, daß als Eingänge der Treiber- und Schaltstufe nur die Schalteranschlußleitungen 20 und 22 eingezeichnet wurden, deren äußere Enden in üblicher Weise mit der Gleichrichterbrücke 24 zu verbinden sind, wie dies in Fig. 1 gezeigt ist.

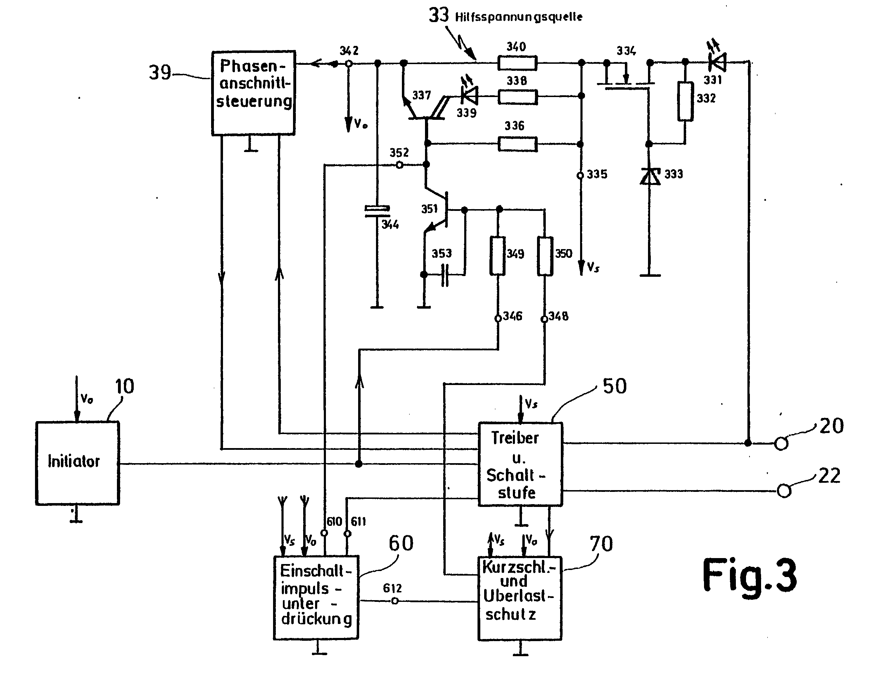

In dem Schaltbild gemäß Fig. 3 sind die vorstehend angesprochenen Schaltkreise 10, 39, 50, 60 und 70 wieder als Blöcke dargestellt, während für eine bevorzugte Ausführungsform der Hilfsspannungsquelle 33 ein detailliertes Schaltbild gezeigt ist.

Im einzelnen umfaßt die Hilfsspannungsquelle 33 gemäß Fig. 3 eingangsseitig eine Leuchtdiode 331, deren Anode direkt mit der Schalteranschlußleitung 20 bzw. mit dem + -Ausgang der Gleichrichterbrücke 24 verbunden ist. Die Kathode der Leuchtdiode 331 ist über einen Widerstand 332 und eine Z-Diode 333 mit Bezugspotential und außerdem direkt mit der Drain-Elektrode eines V-MOS-Transistors 334 verbunden, dessen Gate-Elektrode an den Verbindungspunkt des Widerstands 332 mit der Z-Diode 333 angeschlossen ist. Die Source-Elektrode des Transistors 334 ist direkt an einen Ausgangsanschluß 335 der Hilfsspannungsquelle 33 angeschlossen, an dem eine erhöhte positive Spannung $V_s$ abgegriffen werden kann, wie dies weiter unten noch näher erläutert wird. Ferner ist die Source-Elektrode über einen Widerstand 336 mit der Basis eines Darlington-Transistors 337, über die Serienschaltung eines Widerstandes 338 und einer Leuchtdiode 339 mit dem Kollektor des Transistors 337 und über einen Widerstand 340 mit dem Emitter dieses Transistors 337 verbunden, der den Ausgang 342 der Hilfsspannungsquelle 33 bildet, wobei parallel zum Ausgang bzw. zwischen dem Ausgang 342 und Bezugspotential ein größerer Kondensator 344 liegt und wobei am Ausgang 342 während des Betriebes eine kleinere pulsierende Gleichspannung $V_0$ zur Verfügung steht.

Zwei weitere Eingänge 346 und 348 der Hilfsspannungsquelle 33 sind jeweils über einen Widerstand 349 bzw. 350 mit der Basis eines Transistors 351 verbunden, des sen Kollektor einen weiteren Eingang 352 der Hilfsspannungsquelle 33 bildet und mit der Basis des Darlington-Transistors 337 verbunden ist, während sein Emitter mit Bezugspotential und außerdem über einen Kondensator 353 mit seiner Basis verbunden ist.

Die Hilfsspannungsquelle 33 arbeitet wie folgt:

Bei einer von Null auf einen positiven Wert ansteigenden Spannung auf der Leitung 20 wird der Transistor 334 praktisch sofort leitend gesteuert, so daß am Ausgang 335 die Spannung $V_s$ bis auf einen Maximalwert ansteigt, der durch die Z-Diode 333 vorgegeben ist. Beim Ausführungsbeispiel wurde für die Spannung $V_s$ ein Maximalwert von etwa 15 V vorgegeben. Dies wird durch eine um den Spannungsabfall über den Transistor 334 (etwa 2 V) höhere Durchbruchspannung der Z-Diode 333 erreicht.

Die Aufladung des Kondensators 344 erfolgt über den Darlington-Transistor 337, der bei einer entsprechenden Ausgangsspannung an der Source-Elektrode des Transistors 334 leitend gesteuert wird, wobei der in Serie zur Schaltstrecke des Transistors 337 liegende Widerstand zur Strombegrenzung dient und wobei die Leuchtdiode 339 das Fließen eines Ladestroms zum Kondensator 334 anzeigt. (Funktionsanzeige) Der Transistor 351 dient dazu, bei entsprechenden Ausgangssignalen der Schaltung 70 bzw. des Indikators 10 eine Sperrung des Transistors 337 herbeizuführen. Weiterhin kann der Transistor 337 durch ein Ausgangssignal der Schaltung 60 zur Einschaltimpulsunterdrückung gesperrt werden.

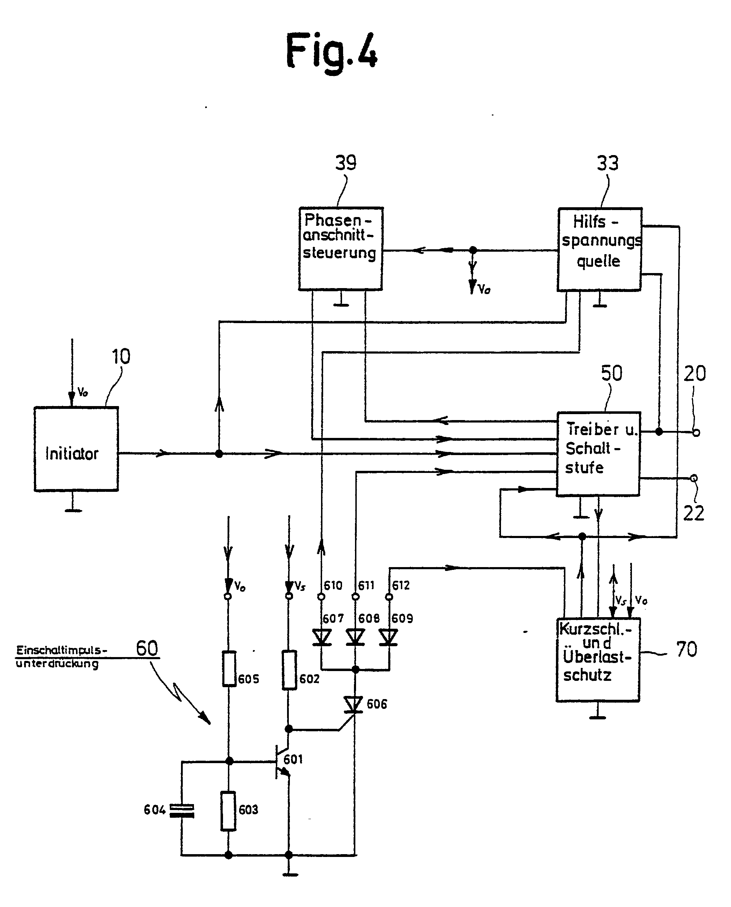

Die Schaltung 60 zur Einschaltimpulsunterdrückung ist in Fig. 4 detailliert dargestellt und umfasst einen Transistor 601, dessen Emitter an Bezugspotential liegt und dessen Kollektor über einen Widerstand 602 mit dem Anschluß 335 der Hilfsspannungsquelle 33 verbunden ist. Die Basis des Transistors 601 liegt über die Parallelschaltung eines Widerstandes 603 und eines Kondensators 604 an Bezugspotential und über einen Widerstand 605 am Anschluß 342 der Hilfsspannungsquelle 33. Weiterhin umfasst die Schaltung 60 einen Thyristor 606, dessen Kathode an Bezugspotential liegt, dessen Steuerelektrode mit dem Kollektor des Transistors 601 verbunden ist und dessen Anode über Entkoppelungsdioden 607, 608 und 609 mit drei Ausgangsanschlüssen 610, 611 und 612 verbunden ist.

Beim Einschalten des Zweidrahtschalters erscheint am Anschluß 335 der Hilfsspannungsquelle praktisch verzögerungsfrei die Spannung $V_s$, die den Thyristor 606 über dessen Steuerelektrode leitend steuert, so daß über die Ausgänge 610, 611 und 612 eine Sperrung des Transistors 337 der Hilfsspannungsquelle 33 sowie in noch näher zu erläuternder Weise eine Sperrung der Treiber- und Schaltstufe 50 und der Kurzschluß- und Überlastschutzschaltung 70 erfolgt. Erst wenn sich die Spannung $V_o$ über dem Kondensator 344 in Abhängigkeit von dem Ladestrom über den Widerstand 340 bis auf einen ausreichend hohen Wert aufgebaut hat, der ein einwandfreies Funktionieren der verschiedenen Schaltkreise gewährleistet, wird der Transistor 601 leitend gesteuert und legt damit Bezugspotential an die Steuerelektrode des Thyristors 606, so daß dieser gesperrt wird und die zuvor gesperrten Schaltkreise bzw. Schaltkreisteile für den normalen Betrieb freigibt. Dabei ist zu beachten, daß der Thyristor 606 so ausgewählt bzw. geschaltet wird, daß er im leitenden Zustand nur einen unterhalb seines Haltestroms liegenden Strom führt und folglich durch das Absinken seiner Steuerspannung gesperrt werden kann. Sobald der Thyristor 606 gesperrt ist, wird der Darlington-Transistor 337 leitend, so daß der Strom zu dem Kondensator 344 nunmehr über die niederohmige Schaltstrecke dieses Transistors fließen kann.

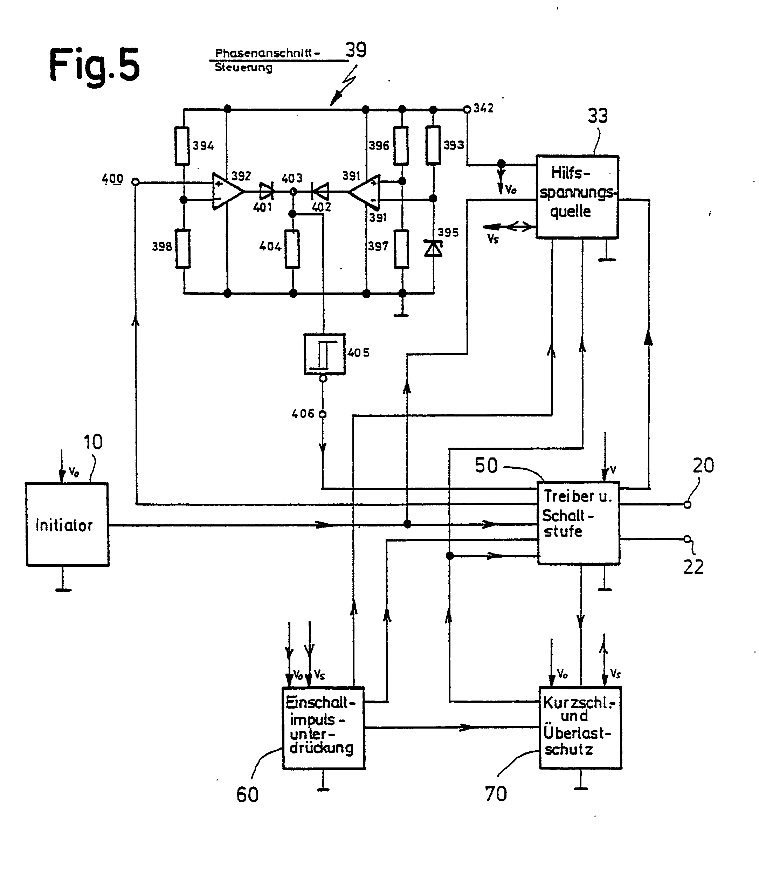

Die Hilfs- bzw. Versorgungsspannung $V_o$ am Ausgang 342 wird, u.a. auch der Phasenanschnittsteuerung 39 zugeführt, deren Aufbau nachstehend anhand von Fig. 5 der Zeichnung näher erläutert wird.

Wie Fig. 5 zeigt, umfasst die Phasenanschnittsteuerung 39 zwei Operationsverstärker 391, 392, deren invertierende Eingänge (-) jeweils über einen Widerstand 393 bzw. 394 mit dem Ausgang 342 der Speisespannungsquelle 33 verbunden sind. Außerdem liegt der invertierende Eingang des Operationsverstärkers 391 über eine Z-Diode 395 an Bezugspotential. Der nicht invertierende Eingang (+) des Operationsverstärkers 391 liegt am Abgriff eines Spannungsteilers aus zwei Widerständen 396, 397. Der Operationsverstärker 391 liefert also dann ein positives Ausgangssignal, wenn die Spannung am nicht invertierenden Eingang positiver ist als eine durch die Z-Diode 395 vorgegebene Bezugsspannung. Der invertierende Eingang des anderen Operationsverstärkers 392 liegt über einen weiteren Widerstand 398 an Bezugspotential; die Widerstände 394 und 398 bilden also einen Spannungsteiler, mit dessen Abgriff der invertierende Eingang des Operationsverstärkers 392 verbunden ist. Der nicht-invertierende Eingang (+) des Operationsverstärkers 392, der ebenso wie der erste Operationsverstärker 391 als Komparator geschaltet ist, ist, wie weiter hinten noch näher ausgeführt wird, in der Treiber- und Schaltstufe 50 mit einem Schaltungspunkt 400 verbunden, an dem eine Spannung ansteht, die dem Strom im Lastkreis des Zweidraht-Schalters entspricht. Die Ausgänge der beiden Operationsverstärker sind über Entkoppelungsdioden 401, 402 mit einem Schaltungspunkt 403 verbunden, der über einen Widerstand 404 an Bezugspotential und über eine Triggerschaltung 405 mit negiertem Ausgang mit dem Ausgangsanschluß 406 der Phasenanschnittsteuerung 39 verbunden ist.

Aufgrund des vorstehend beschriebenen Aufbaus erscheint am Schaltungspunkt 403 zu Beginn jedes Impulses der pulsierenden Gleichspannung zunächst keine positive Spannung, bis das Signal am + -Eingang des Operationsverstärkers 391 größer wird als die Referenzspannung über die Z-Diode 395. Während dieser Phase erzeugt die Triggerschaltung 405 ein Ausgangssignal niedrigen Pegels, welches durch Invertierung in ein Signal hohen Pegels umgesetzt wird, welches einer logischen "1" entspricht. Wenn dann am nicht-invertierenden Eingang des Operationsverstärkers 391 eine über der Referenzspannung liegende Spannung erreicht wird, dann ergibt sich am Schaltungspunkt 403 ein positives Signal, welches am Ausgang der Triggerschaltung 405 ein Signal hohen Pegels zur Folge hat, welches durch Invertieren zu einem einer logischen "0" entsprechenden Signal niedrigen Pegels wird. Solange im Lastkreis des Zweidraht-Schalters kein Strom fließt bzw. solange ein Lasttransistor der Treiber- und Schaltstufe 50 gesperrt ist, ist außerdem das Signal am nicht-invertierenden Eingang des Operationsverstärkers 392 kleiner als das Signal am invertierenden Eingang desselben, so daß der zweite Operationsverstärker 392 am Schaltungspunkt 403 ein Signal niedrigen Pegels erzeugt. Sobald jedoch der Lasttransistor durchgeschaltet ist, ergibt sich am Ausgang des zweiten Operationsverstärkers 392 ein Signal hohen Pegels. Dieses Signal endet erst, wenn der Strom im Lastkreis gegen Ende eines Impulses der pulsierenden Gleichspannung hinreichend weit abgesunken ist. Obwohl die Hilfsspannung U am nicht-invertierenden Eingang des ersten Operationsverstärkers 391 im Verlauf eines Impulses der pulsierenden Gleichspannung wieder unter die Referenzspannung an der Z-Diode 395 absinkt, bleibt also das invertierte Ausgangssignal der Triggerschaltung 405, nachdem es auf einen niedrigen Pegel gesprungen ist, bis zum Ende des betreffenden Impulses auf einem niedrigen Pegel, der einer logischen "0" entspricht. Die Phasenanschnittsteuerung 39 bildet also bei dem betrachteten Ausführungsbeispiel praktisch ein ODER-Gatter, welches dem ODER-Gatter 40 der logischen Schaltung 38 des Zweidraht-Schalters gemäß Fig. 1 entspricht.

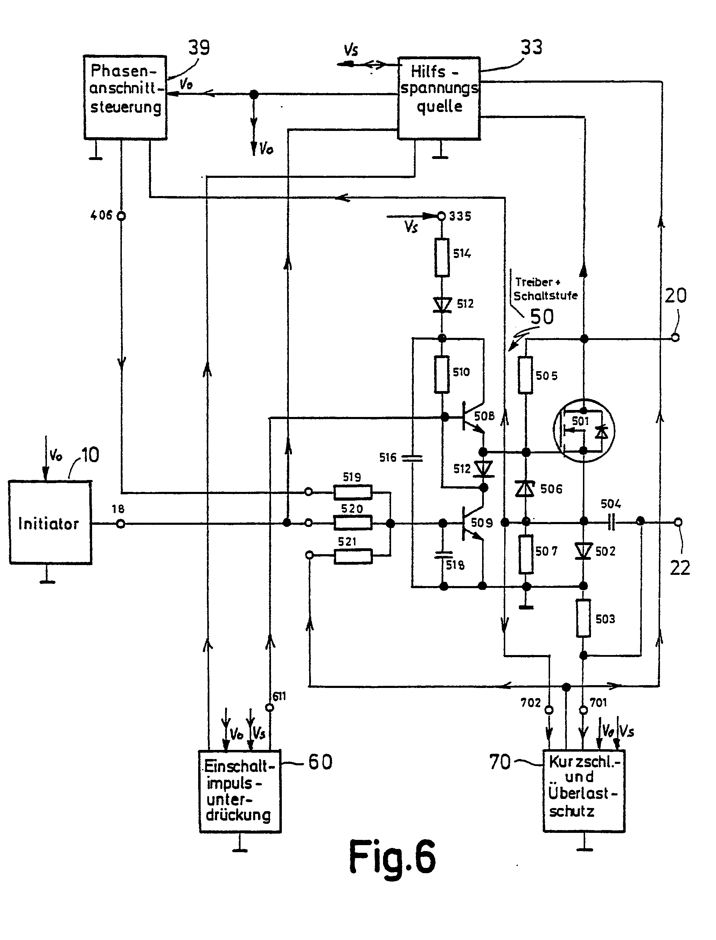

In Fig. 6 ist die Treiber- und Schaltstufe 50 detailliert dargestellt. Der Lastkreis enthält zwischen den Schalteranschlußleitungen 20,22 die Serienschaltung eines Lasttransistors 501, einer Diode 502 und eines Widerstandes 503. Parallel zu der Serienschaltung 502, 503 liegt ein Entstörkondensator 504. Die Gate-Elektrode des als V-MOS-Leistungstransistor ausgebildeten Lasttransistors 501 ist über einen Widerstand 505 mit der Anschlußleitung 20 verbunden. Parallel zur Gate-Source-Strecke des Transistors 501 liegt eine Z-Diode 506. Ferner liegt parallel zu der Diode 502 ein Widerstand 507, dessen von der Source-Elektrode abgewandtes Ende an Bezugspotential liegt. Ferner ist eine Gegentaktstufe mit zwei Transistoren 508, 509 vorgesehen, deren Kollektor-Emitter-Strecken in Serie geschaltet sind, wobei der Verbindungspunkt des Emitters des Transistors 508 mit dem Kollektor des Transistors 509 mit der Gate-Elektrode des Transistors 501 verbunden ist. Der Kollektor des Transistors 509 ist außerdem direkt mit der Basis des Transistors 508 verbunden, die außerdem mit dem Ausgang 611 der Schaltung 60 verbunden ist. Ferner ist die Basis des Transistors 508 über einen Widerstand 510 mit dessen Kollektor verbunden, der über die Serienschaltung einer Diode 512 und eines Widerstandes 514 mit dem Ausgang 335 der Hilfsspannungsquelle 33 verbunden ist. Zwischen dem Kollektor des Transistors 508 und dem Emitter des Transistors 509 liegt ferner ein Kondensator 516 als Speicherkondensator. Ein Entstörkondensator 518 liegt zwischen der Basis und dem Emitter des Transistors 509. Die Basis des Transistors 509 ist ferner über Entkoppelungswiderstände 519, 520 und 521 mit dem Ausgang 18 des Initiators, mit einem Ausgang der Kurzschluß- und Überlastschutzschaltung 70 und mit dem Ausgang 406 der Phasenanschnittsteuerung 39 verbunden. Die Widerstände 519, 520, 521 dienen dabei gleichzeitig zur Strombegrenzung und Entkopplung.

Bei der Treiber- und Schaltstufe 50 gemäß Fig. 6 wird der Lasttransistor 501 dann leitend gesteuert, wenn der Transistor 508 der Gegentaktstufe leitend gesteuert wird und die erhöhte Spannung $V_s$ vom Anschluß 335 der Hilfsspannungsquelle 33 zu der Gate-Elektrode des Transistors 501 durchschaltet. Der Transistor 508 bleibt jedoch so lange gesperrt, wie der Transistor 509 leitend gesteuert ist und die Basis des Transistors 508 an Bezugspotential legt. Außerdem wird der Transistor 508 während der Einschaltphase dadurch im gesperrten Zustand gehalten, daß seine Basis über den Anschluß 611 der Schaltung 60 zur Einschaltimpulsunterdrückung an Bezugspotential gelegt wird. Der Transistor 509 wird dann leitend gesteuert, wenn seiner Basis vom Ausgang 18 des Initiators 10 oder vom Ausgang 406 der Phasenanschnittsteuerung 39 über den Widerstand 520 bzw. den Widerstand 519 ein Signal hohen Pegels zugeführt wird, welches einer logischen "1" entspricht. Dies ist dann der Fall, wenn entweder der Initiator 10 ein Sperrsignal erzeugt, welches einer logischen "1" entspricht, oder wenn mit Hilfe der Phasenanschnittsteuerung 39 ein einer logischen "1" entsprechendes Signal hohen Pegels erzeugt wird, was dann der Fall ist, wenn keiner der beiden Operationsverstärker 391, 392 ein positives Ausgangssignal liefert, was während eines vorgegebenen Zeitintervalls zu Beginn jedes Impulses der pulsierenden Gleichspannung der Fall ist. Der Transistor 509 wird also leitend gesteuert, wenn entweder ein Sperrsignal des Initiators 10 vorliegt oder wenn keiner der Operationsverstärker 391, 392 ein positives Ausgangssignal liefert, was einer ODER-Verknüpfung an den Schaltungspunkten 18 und 406 entspricht. Andererseits wird der Transistor 508 dann leitend gesteuert, wenn der Transistor 509 gesperrt wird, nämlich dann, wenn ein Durchsteuersignal des Initiators 10 in Form eines einer logischen "0" entsprechenden Signals niedrigen Pegels vorhanden ist und wenn gleichzeitig mindestens einer der beiden Operationsverstärker 391, 392 ein positives Ausgangssignal liefert. Somit ergibt sich für den Schaltzustand des Transistors 508 letztlich wieder eine UND-Verknüpfung, wenn man von den beim Ausführungsbeispiel aus schaltungstechnischen Gründen vorgesehenen Negationen verschiedener Signale absieht. Die beschriebene Art der Verknüpfung der Ausgangssignale der Phasenanschnittsteuerung 39 und des Initiators 10 wurde deshalb gewählt, um zusätzlich das Ausgangssignal der Kurzschluß- und Überlastschutzschaltung 70 in die ODER-Verknüpfung für die Ansteuerung des Transistors 509 der Gegentaktstufe einbauen zu können. Die Gegentaktschaltung einschließlich der eingangsseitig vorgesehenen Widerstände 519, 520 und 521 entspricht also beim betrachteten Ausführungsbeispiel dem UND-Gatter 42 der logischen Schaltung 38 des Ausführungsbeispiels gemäß Fig. 1.

Wenn der Transistor 508 in Abhängigkeit von einem Durchsteuersignal des Indikators 10 bei gleichzeitigem positivem Ausgangssignal des ersten Operationsverstärkers 391 leitend gesteuert wird, legt er die höhere Spannung $V_s$ von z.B.ca.10 bis 14 V an die Gate-Elektrode des Last-Transistors 501, so daß dieser leitend gesteuert wird, womit der Phasenanschnitt beendet ist, da die Spannung zwischen den Leitungen 20 und 22 sofort auf eine niedrige Restspannung abfällt, wodurch gleichzeitig die Spannung $V_s$ am Schaltungspunkt 335 zusammenbricht. Nunmehr wird die erforderliche Gate-Spannung von etwa 8 bis 10 V für den Transistor 501 von dem zuvor aufgeladenen Speicherkondensator 516 geliefert.

Der Transistor 501 bleibt also leitend, wobei der im Lastkreis fließende Strom über dem Widerstand 507 einen Spannungsabfall erzeugt, der zunächst ausreichend hoch ist, um ein positives Ausgangssignal des zweiten Operationsverstärkers 392 zu bewirken. Damit bleibt der hohe Spannungspegel am Schaltungspunkt 403 erhalten, selbst wenn die Spannung über dem Speicherkondensator 344 allmählich wieder unter den durch die Z-Diode 395 vorgegebenen Schwellwert für den ersten Operationsverstärker 391 absinkt. Gegen Ende des laufenden Impulses der pulsierenden Gleichspannung fällt die Spannung über dem Widerstand 507 dann so weit ab, daß das positive Signal am Ausgang des Operationsverstärkers 392 endet und der Lasttransistor 501 gesperrt wird. Es wird also mit einem Phasenanschnitt gearbeitet, um während jeder Halbwelle der auf der Eingangsseite der Brücke 24 anliegenden Wechselspannung in den Speicherkondensatoren 344 und 516 jeweils eine ausreichende Energiemenge für den Betrieb der Gesamtschaltung während der nun folgenden Durchschaltphase des Transistors 501 zu speichern. Durch die Parallelschaltung des Widerstandes 507 zu der Diode 502 wird dabei aufgrund der linearen Widerstandscharakteristik des Widerstandes 507 sichergestellt, daß der Transistor 501 am Ende jeder Halbwelle der Wechselspannung zuverlässig gesperrt wird, so daß der Phasenanschnitt in der Praxis auch erreicht wird. Der Widerstand 507 bestimmt also den Haltestrom im Lastkreis. Die Z-Diode 506 schützt den Transistor 501 gegen eine zu hohe Gate-Source-Spannung.

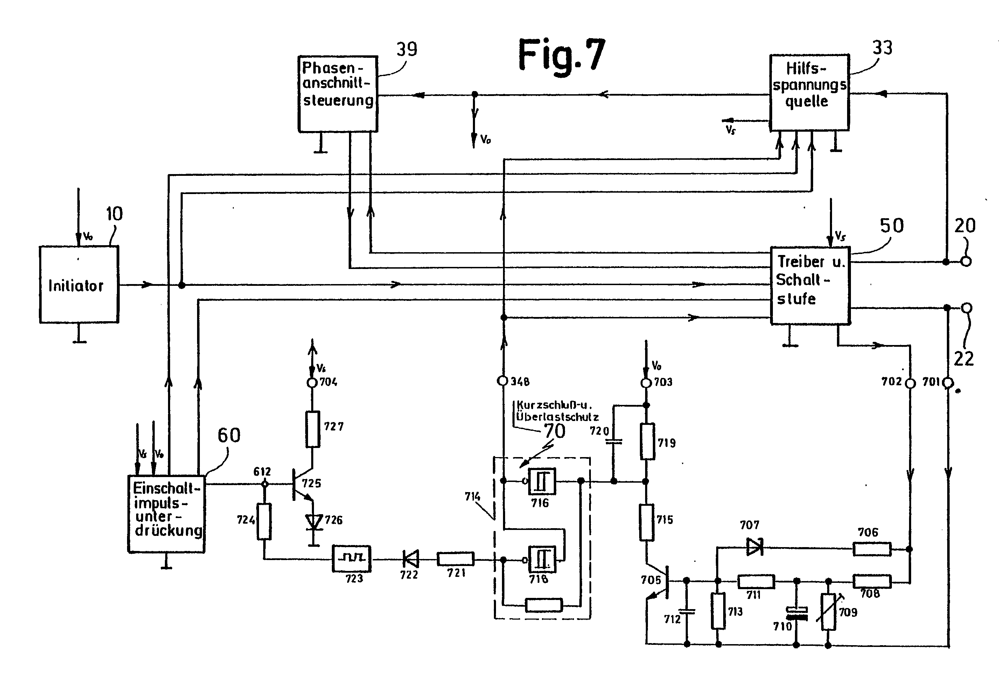

Die eingangs erwähnte Kurzschluß- und Überlastschutzschaltung ist in Fig. 7 detailliert dargestellt und soll nachstehend im einzelnen näher erläutert werden.

Die Kurzschluß- und Überlastschutzschaltung 70 ist einerseits direkt an einem Eingangsanschluß 701 mit der Schalteranschlußleitung 22 verbunden und außerdem mit einem Eingangsanschluß 702 mit der Source-Elektrode des Transistors 501. Zwei weitere Anschlüsse 703 und 704 sind mit den Anschlüssen 342 bzw. 335 der Hilfsspannungsquelle 33 verbunden, an denen die Spannungen $V_0$ und $V_s$ anliegen. Ein Transistor 705, dessen Emitter mit dem Anschluß 701 verbunden ist, wird bei einem Kurzschluß die Serienschaltung eines Widerstandes 706 und einer Z-Diode 707 zwischen seiner Basis und dem Anschluß 702 verzögerungsfrei leitend gesteuert, wenn über dem Widerstand 503 des Lastkreises eine Spannung ansteht, die einem Kurzschlußstrom entspricht, wobei die Z-Diode 707 der Erzeugung einer definierten Schaltschwelle dient. Eine verzögerte Ansteuerung des Transistors 705 erfolgt über ein RC-Glied mit den Widerständen 708 und 709 und einem Kondensator 710, der über einen Widerstand 711 mit der Basis des Transistors 705 verbunden ist. Ferner ist die Basis des Transistors 705 über einen Kondensator 712 und einem dazu parallel geschalteten Widerstand 713 mit dem Anschluß 701 verbunden. Mit Hilfe des durch den Transistor 705 verstärkten Abschaltsignals wird ein Flip-Flop 714 angesteuert, welches über einen Widerstand 715 mit dem Kollektor des Transistors 705 verbunden ist. Das Flip-Flop 714 besteht beim Ausführungsbeispiel aus zwei ausgangsseitig miteinander gekoppelten, invertierenden Schmitt-Triggern 716 und 718. Das Flip-Flop wird beim Einschalten der Betriebsspannung durch die Spannung $V_0$ am Anschluß 703 über die Parallelschaltung eines Widerstandes 719 und eines Kondensators 720 zurückgesetzt, falls zuvor der Kurzschlußschutz angesprochen hatte. Wenn dann der Transistor 705 leitend gesteuert wird, gelangt das Flip-Flop 714 in seinen zweiten stabilen Zustand, wobei das negierte Ausgangssignal des Schmitt-Triggers 716 über den Eingangsanschluß 348 und den Widerstand 350 der Basis des Transistors 351 der Hilfsspannungsquelle 33 zugeführt wird und diesen Transistor leitend steuert, so daß der Transistor 337 gesperrt wird, was zur Folge hat, daß die durch die Leuchtdiode 339 realisierte Funktionsanzeige erlischt. Gleichzeitig wird durch das invertierte Ausgangssignal des Schmitt-Triggers 718 über einen Widerstand 721 und eine Diode 722 eine astabile Kippstufe 723 mit negiertem Ausgang freigegeben, wodurch über einen Widerstand 724 ein Transistor 725 getaktet leitend gesteuert wird, dessen Emitter über eine Diode 726 mit Bezugspotential verbunden ist und dessen Kollektor über einen Widerstand 727 mit dem Anschluß 704 verbunden ist, der seinerseits dem Anschluß 335 der Hilfsspannungsquelle 33 entspricht bzw. mit diesem verbunden ist. Der leitend gesteuerte Transistor 725 zieht den Drain-Anschluß des Transistors 334 gegen Bezugspotential, wobei bei jedem Impuls der astabilen Kippstufe ein hoher Strom über den Transistor 334 und über die damit in Serie geschaltete Leuchtdiode 331 fließt, so daß diese Diode, welche normalerweise nur schwach leuchtet, nach Ansprechen des Kurzschlußschutzes helle Lichtblitze erzeugt, die den Störfall signalisieren. Beim Einschalten der Betriebsspannung verhindert die Verbindung zwischen dem Anschluß 612 der Schaltung 60 und der Basis des Transistors 725 ein Durchschalten desselben.

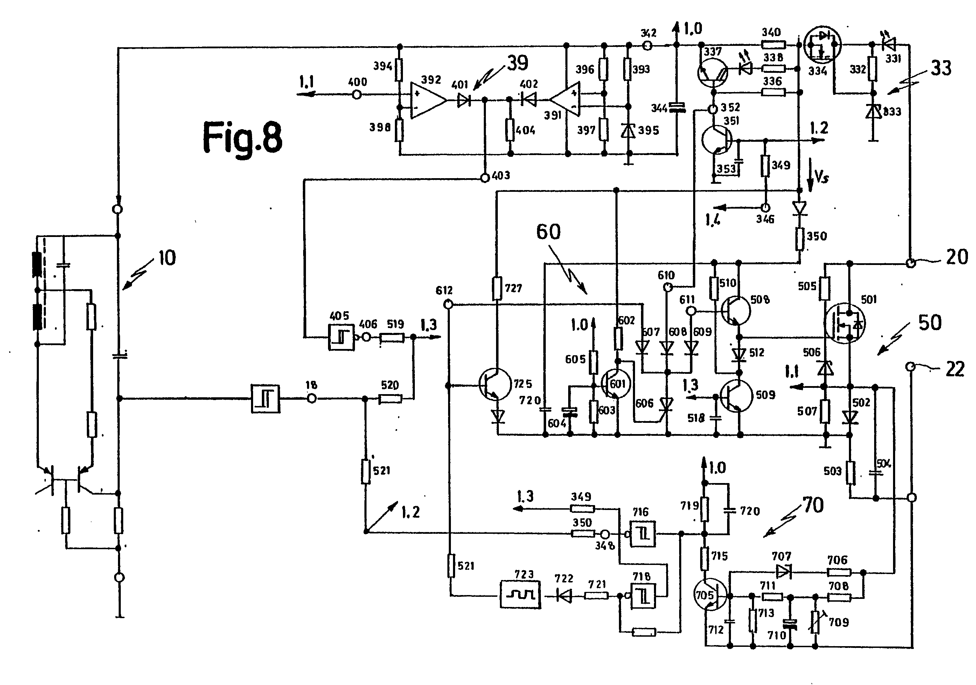

Die vorstehend anhand der Figuren 3 bis 7 erläuterten Einzelschaltungen sind in dem Gesamtschaltbild gemäß Fig. 8 gemeinsam dargestellt. Dabei enthält das Gesamtschaltbild zusätzlich ein detaillierteres Schaltbild des Initiators 10. Auf eine nähere Erläuterung der Funktion der Initiatorschaltung kann dabei im vorliegenden Zusammenhang verzichtet werden, da der Initiator mit Ausnahme besonderer Schaltkreisteile, die der Funktionsprüfung des Initiators selbst dienen können, vollständig einem konventionellen Initiator entspricht, wie er beispielsweise in Fig. 1 der DE-OS 30 07 929 gezeigt ist, wobei jedoch die Triggerstufe, zu der bei dem bekannten Initiator die Transistoren T3 und T4 gehören, nur als Block dargestellt ist.

## Patentansprüche

1. Zweidraht-Schalter mit einem Leistungstransistor, insbesondere einem V-MOS-Transistor (30, 501), welcher in Serie mit einer Hilfsimpedanz (32; 502, 503, 507) zwischen zwei Schalteranschlußleitungen (20, 22) liegt, die mit den Polen einer Gleichspannungsquelle zur Erzeugung einer zwischen Null und einem Maximalwert pulsierenden Gleichspannung verbindbar sind, mit einem, insbesondere berührungslos, von außen beeinflußbaren Initiator (10) zur Erzeugung von Sperr- und Durchsteuersignalen für den Transistor und mit einer Hilfsspannungsquelle (33) zur Erzeugung einer mit dem Takt der pulsierenden Gleichspannung pulsierenden Hilfsspannung (V₀),
**dadurch gekennzeichnet,**
daß eine logische Schaltung (38) vorgesehen ist, die einen nach einer ODER-Funktion arbeitenden, einen ersten Eingang (a) und einen zweiten Eingang (b) aufweisenden Schaltungsteil (40) und einen nach einer UND-Funktion arbeitenden, zwei Eingänge aufweisenden Schaltungsteil (42) aufweist, dessen einer Eingang mit dem Ausgang des ersten Schaltungsteils (40) verbunden ist, und dessen anderer Eingang einen dritten Eingang (c) der logischen Schaltung (38) bildet, daß der erste Eingang (a) mit dem Ausgang der Hilfsspannungsquelle (33) verbunden ist, daß der zweite Eingang (b) mit einem gemeinsamen Verbindungspunkt von Leistungstransistor (30) und Hilfsimpedanz (32) verbunden ist und daß der dritte Eingang (c) mit dem Ausgang (18) des Initiators (10) verbunden ist und daß die logische Schaltung (38) derart ausgebildet ist, daß der Leistungstransistor (30) durch ein Sperrsignal des Initiators (10) jederzeit sperrbar ist und durch ein Durchsteuersignal des Initiators (10) dann für den Rest des laufenden Impulses der pulsierenden Gleichspannung durchsteuerbar ist, wenn die Spannung am ersten oder zweiten Eingang (a bzw. b) der logischen Schaltung (38) einen einer logischen "1" entsprechenden Schwellwert übersteigt.

2. Zweidraht-Schalter nach Anspruch 1, dadurch gekennzeichnet, daß die Hilfsspannungsquelle durch einen zwischen den Schalteranschlußleitungen (20,22) liegenden Spannungsteiler (34,36) gebildet ist, mit dessen Abgriff der erste Eingang (a) der logischen Schaltung (38) verbunden ist.

3. Zweidraht-Schalter nach Anspruch 1, dadurch gekennzeichnet, daß die Hilfsspannungsquelle (33) als Spannungsregler mit einem Speicherglied (344) ausgebildet ist.

4. Zweidraht-Schalter nach Anspruch 3, dadurch gekennzeichnet, daß die Hilfsspannungsquelle eingangsseitig einen Transistor (334) aufweist, dessen einer Schaltstreckenanschluß mit der Schalteranschlußleitung (20) verbunden ist, dessen Steuerelektrode mit dieser Schalteranschlußleitung (20) über einen Widerstand (332) und über eine Z-Diode (333) mit dem durch die andere Schalteranschlußleitung (22) gebildeten Bezugspotential verbunden ist und dessen anderer Schaltstreckenanschluß über einen Widerstand (340) mit dem Ausgang (342) der Hilfsspannungsquelle (33) verbunden ist, der außerdem über einen als Speicherglied dienenden Kondensator (344) mit Bezugspotential verbunden ist, daß parallel zu dem Widerstand (340) die Serienschaltung der Schaltstrecke eines weiteren Transistors (337) und eines Widerstandes (338) vorgesehen ist, und daß die Basis des weiteren Transistors (337) über einen Widerstand (336) mit dem gemeinsamen Verbindungspunkt der Widerstände (338, 340) verbunden ist, wobei dieser Schaltungspunkt einen weiteren Ausgang (335) der Hilfsspannungsquelle (33) bildet, an dem im Betrieb eine Spannung (Vₛ) verfügbar ist, die größer ist als die Spannung (V₀) am ersten Ausgang (342) der Hilfsspannungsquelle (33).

5. Zweidraht-Schalter nach Anspruch 4, dadurch gekennzeichnet, daß der mit der einen Schalteranschlußleitung (22) verbundene Transistor ein V-MOS-Transistor (334) ist und daß der weitere Transistor ein Darlington-Transistor (337) ist.

6. Zweidraht-Schalter nach Anspruch 4 oder 5, dadurch gekennzeichnet, daß in den Schaltstreckenzweig jedes der Transistoren (334, 337) jeweils eine Diode (331 bzw. 339) zur Anzeige einer Kurzschlußbedingung bzw. zur Funktionsanzeige eingefügt ist, daß der weitere Ausgang (335) der Hilfsspannungsquelle (33) in Abhängigkeit vom Ansprechen einer Kurzschluß- und Überlastschutzschaltung (70) periodisch mit Bezugspotential verbindbar ist, um einen hohen Strom über die Schaltstrecke des eingangsseitigen Transistors (334) und die in Serie dazu liegende Leuchtdiode (331) zu ziehen, so daß diese periodisch blinkt, und daß die Basis des weiteren Transistors (337) in Abhängigkeit vom Ansprechen der Kurzschluß- und Überlastschutzschaltung (70) sowie in Abhängigkeit vom Ansprechen einer Schaltung (60) zur Einschaltimpulsunterdrückung an ein Sperrpotential anlegbar ist, so daß die der Funktionsanzeige dienende Leuchtdiode (339) im Schaltstreckenzweig dieses Transistors (337) erlischt und der Strom über den weiteren Transistor (337) gesperrt wird.

7. Zweidraht-Schalter nach einem der Ansprüche 1 bis 6, dadurch gekennzeichnet, daß eine Schaltung (60) zur Einschaltimpulsunterdrückung vorgesehen ist, durch die für eine vorzugsweise einstellbare Verzögerungszeit nach Einschalten der Gleichspannungsquelle (24) ein Sperrsignal erzeugbar ist, durch welches der Leistungstransistor (501) sperrbar ist.

8. Zweidraht-Schalter nach Anspruch 7, dadurch gekennzeichnet, daß die Schaltung (60) zur Einschaltimpulsunterdrückung einen Thyristor (606) aufweist, der bei Einschalten der Gleichspannungsquelle (24) über seine Steuerelektrode verzögerungsfrei leitend steuerbar ist, um ein Sperrsignal zu erzeugen, sowie einen weiteren steuerbaren Halbleiterschalter (601), der in Abhängigkeit von einer mit Hilfe eines Zeitglieds (603, 604, 605) ausgehend von der Ausgangsspannung (V₀) der Hilfsspannungsquelle (33) erzeugten Steuerspannung betätigbar ist, um ein Sperrsignal für den Thyristor zu erzeugen.

9. Zweidraht-Schalter nach Anspruch 8, dadurch gekennzeichnet, daß das Zeitglied (603,604,605) durch eine Widerstands/Kondensator-Kombination gebildet ist.

10. Zweidraht-Schalter nach Anspruch 9, dadurch gekennzeichnet, daß mindestens einer der Widerstände (603,605) der Widerstands/-Kondensator-Kombination (603,604,605) als einstellbarer Widerstand ausgebildet ist.

11. Zweidraht-Schalter nach einem der Ansprüche 7 bis 10, dadurch gekennzeichnet, daß das Sperrsignal der Schaltung (60) zur Einschaltimpulsunterdrückung weiteren Schaltkreisen (33,70) zur Sperrung derselben zuführbar ist.

12. Zweidraht-Schalter nach einem der Ansprüche 1 bis 11, dadurch gekennzeichnet, daß eine Kurzschluß-und Überlastschutzschaltung (70) vorgesehen ist, durch die zumindest für die Dauer einer Kurzschluß- bzw. Überlastbedingung ein Sperrsignal erzeugbar ist, durch welches der Leistungstransistor (501) sperrbar ist, und durch welches gegebenenfalls weitere Schaltkreise (33) sperrbar sind.

13. Zweidraht-Schalter nach Anspruch 12, dadurch gekennzeichnet, daß die Schutzschaltung (70) zur Erzeugung des Sperrsignals einen steuerbaren elektrischen Schalter (705) aufweist, der verzögerungsfrei über einen eine Z-Diode (707) enthaltenden Eingangszweig und verzögert über einen ein Zeitglied (708, 709,710), insbesondere ein RC-Glied (708, 709,710), enthaltenden weiteren Eingangszweig ansteuerbar ist, und daß die beiden Eingangszweige parallel zueinander an einem Schaltungspunkt des den Leistungstransistor (501) enthaltenden Leistungskreises angeschlossen sind, an dem eine dem Strom über den Leistungstransistor (501) entsprechende Spannung abgreifbar ist.

14. Zweidraht-Schalter nach Anspruch 12 oder 13, dadurch gekennzeichnet, daß als Ausgangskreis der Schutzschaltung (70) eine Speicherschaltung (714) vorgesehen ist.

15. Zweidraht-Schalter nach Anspruch 14, dadurch gekennzeichnet, daß mit einem Ausgang der Speicherschaltung (714) ein astabiler Multivibrator verbunden ist, durch dessen Ausgangssignal eine Leuchtdiode (331) zur Erzeugung periodischer Blinksignale ansteuerbar ist.

16. Zweidraht-Schalter nach einem der Ansprüche 13 bis 15, dadurch gekennzeichnet, daß als steuerbarer elektrischer Schalter (705) der Schutzschaltung (70) ein Transistor (705) vorgesehen ist, dessen Basis mit den vom Leistungskreis abgewandten Enden der parallelen Eingangszweige verbunden ist, und dessen Emitter direkt mit der einen Schalteranschlußleitung (22) verbunden ist, und daß der mit den von der Basis abgewandten Enden der parallelen Eingangszweige verbundene Schaltungspunkt des Leistungskreises einerseits mit dem Leistungstransistor (501) und andererseits über eine Diode (502) mit Bezugspotential verbunden ist, und daß zwischen dem an Bezugspotential liegenden Anschluß der Diode (502) und der mit dem Emitter des Transistors (705) der Schutzschaltung (70) verbundenen Schalteranschlußleitung (22) ein niederohmiger Meßwiderstand (503) vorgesehen ist.

17. Zweidraht-Schalter nach einem der Ansprüche 1 bis 16, dadurch gekennzeichnet, daß die Hilfsimpedanz (502, 503) eine einerseits mit der Schaltstrecke des Leistungstransistors (501) und andererseits mit Bezugspotential verbundene Diode (502) umfasst, welcher ein Widerstand (507) parallel geschaltet ist.

18. Zweidraht-Schalter nach einem der Ansprüche 1 bis 17, dadurch gekennzeichnet, daß der nach einer ODER-Funktion arbeitende Schaltungsteil der logischen Schaltung (38) als Phasenanschnittsteuerung (39) mit zwei Operationsverstärkern (391, 392) ausgebildet ist, die beide jeweils als Komparator geschaltet sind und jeweils einen Eingang aufweisen, an dem eine aus der von der Hilfsspannungsquelle (33) erzeugten Spannung (V) abgeleitete Referenzspannung anliegt, daß am zweiten Eingang des einen Operationsverstärkers (391) eine zu der Spannung (V) aus der Hilfsspannungsquelle (33) proportionale Spannung anliegt, daß am zweiten Eingang des anderen Operationsverstärkers (392) eine von der Spannung über der Hilfsimpedanz (502,503,507) abgeleitete Spannung anliegt, und daß die Ausgänge der Operationsverstärker (391,392) mit einem Ausgang (406) der Phasenanschnittsteuerung (39) verbunden sind.

19. Zweidraht-Schalter nach Anspruch 18, dadurch gekennzeichnet, daß am Ausgang (406) der Phasenanschnittsteuerung (39) eine Triggerschaltung (405), gegebenenfalls mit negiertem Ausgang, vorgesehen ist.

20. Zweidraht-Schalter nach Anspruch 6, dadurch gekennzeichnet, daß der weitere Transistor (337) durch ein Sperrsignal des Initiators (10) sperrbar ist.

**Claims**

1. Two-wire type switch with a power transistor, in particular a VMOS transistor (30, 501), arranged in series with an auxiliary impedance (32; 502, 503, 507) between two switch connection lines (20, 22) which are connectable to the poles of a DC voltage source for generating a DC voltage pulsating between zero and a maximum value, with an, in particular, contactlessly, externally influenceable initiator (10) for generating blocking and driving signals for the transistor, and with an auxiliary voltage source (33) for generating an auxiliary voltage ($V_0$) pulsating with the frequency of the pulsating DC voltage, characterized in that a logic circuit (38) is provided, said circuit comprising a circuit component (40) operating in accordance with an OR function and including a first input (a) and a second input (b) and a circuit component (42) operating in accordance with an AND function and including two inputs, one of its inputs being connected to the output of said first circuit component (40) and its other input forming a third input (c) of said logic circuit (38), that the first input (a) is connected to the output of the auxiliary voltage source (33), that the second input (b) is connected to a common connection point of power transistor (30) and auxiliary impedance (32) and that the third input (c) is connected to the output (18) of the initiator (10) and that said logic circuit (38) is designed such that the power transistor (30) is blockable at any point in time by a blocking signal of said initiator (10) and is then drivable by a driving signal of said initiator (10) for the remainder of the instant pulse of the pulsating DC voltage when the voltage at the first or second input (a and b, respectively) of said logic circuit (38) exceeds a threshold value corresponding to a logic "1".

2. Two-wire type switch as defined in claim 1, characterized in that the auxiliary voltage source is formed by a voltage divider (34, 36) arranged between the switch connection lines (20, 22), the first input (a) of said logic circuit (38) being connected to its tap.

3. Two-wire type switch as defined in claim 1, characterized in that the auxiliary voltage source (33) is designed as a voltage regulator with a storage member (344).

4. Two-wire type switch a defined in claim 3, characterized in that the auxiliary voltage source comprises a transistor (334) on its input side, said transistor having a switching path connection connected to the one switch connection line (20) and a control electrode connected to said switch connection line (20) via a resistor (332) and via a Zener diode (333) to the reference potential formed by the other switch connection line (22) and said transistor having a further switching path connection connected via a resistor (340) to the output (342) of said auxiliary voltage source (33), said output also being connected via a capacitor (344) serving as storage member to a reference potential, that the series connection of the switching path of a further transistor (337) and a resistor (338) is provided parallel to the resistor (340), and that the base of said further transistor (337) is connected via a resistor (336) to the common connection point of said resistors (338, 340), this circuit point forming a further output (335) of said auxiliary voltage source (33), at which a voltage ($V_s$) is available during operation, said voltage being larger than the voltage ($V_0$) at the first output (342) of said auxiliary voltage source (33).

5. Two-wire type switch as defined in claim 4, characterized in that said transistor connected to the one switch connection line (22) is a VMOS transistor (334) and that said further transistor is a Darlington transistor (337).

6. Two-wire type switch as defined in claims 4 or 5, characterized in that the switching path branch of each of said transistors (334, 337) includes a diode (331 and 339, respectively) for indicating a short-circuit condition and the functioning state, respectively, that the further output (335) of said auxiliary voltage source (33) is periodically connectable to a reference potential as a function of response of a short-circuit and overload protection circuit (70) in order to draw a high current through the switching path of the transistor (334) on the input side and the light-emitting diode (331) connected in series therewith such that the latter periodically blinks, and that the base of said further transistor (337) is connectable to a blocking potential as a function of response of said short-circuit and overload protection circuit (70) and as a function of response of a circuit (60) for switch-on pulse suppression such that said light-emitting diode (339) serving to indicate the functioning state in the switching path branch of said transistor (337) goes out and the current flowing through said further transistor (37) is blocked.

7. Two-wire type switch as defined in any of claims 1 to 6, characterized in that a circuit (60) for switch-on pulse suppression is provided, said circuit generating a blocking signal for a preferably settable delay time after said DC voltage source (24) is switched on, said blocking signal blocking said power transistor (501).

8. Two-wire type switch as defined in claim 7, characterized in that said circuit (60) for switch-on pulse suppression comprises a thyristor (606) switchable without delay into the conductive state via its controle electrode when the DC voltage source (24) is switched on in order to generate a blocking signal and a further controllable semiconductor switch (601) actuatable as a function of a control voltage generated with the aid of a time member (603, 604, 605) on the basis of the output voltage ($V_0$) of said auxiliary voltage source (33), thereby generating a blocking signal for said thyristor.

9. Two-wire type switch as defined in claim 8, characterized in that said time member (603, 604, 605) is formed by a resistor/capacitor combination.

10. Two-wire type switch as defined in claim 9, characterized in that at least one of the resistors (603, 605) of said resistor/capacitor combination (603, 604, 605) is designed as an adjustable resistor.

11. Two-wire type switch as defined in any of claims 7 to 10, characterized in that said blocking signal of said circuit (60) for switch-on pulse suppression is adapted to be fed to further switching circuits (33, 70) to block said circuits.

12. Two-wire type switch as defined in any of claims 1 to 11, characterized in that a short-circuit and overload protection circuit (70) is provided for generating a blocking signal at least for the duration of a short circuit or overload condition, said signal blocking the power transistor (501) and, if necessary, further switching circuits (33).

13. Two-wire type switch as defined in claim 12, characterized in that the protection circuit (70) for generating the blocking signal has a controllable electric switch (705) activatable withouth delay via an input branch containing a Zener diode (707) and with delay via a further input branch containing a time member (708, 709, 710), in particular an RC member (708, 709, 710), and that said two input branches are connected in parallel to a circuit point of the power circuit containing the power transistor (501), a voltage corresponding to the current flowing through said power transistor (501) being tappable at said point.

14. Two-wire type switch as defined in claims 12 or 13, characterized in that a memory circuit (714) is provided as output circuit of said protection circuit (70).

15. Two-wire type switch as defined in claim 14, characterized in that an astable multivibrator is connected to an output of said memory circuit (714), the output signal of said multivibrator activating a light-emitting diode (331) to generate periodic flashing signals.

16. Two-wire type switch as defined in any of claims 13 to 15, characterized in that a transistor (705) is provided as controllable electric switch (705) of the protection circuit (70), the base of said transistor being connected to the ends of the parallel input branches remote from the power circuit and the emitter of said transistor being connected directly to the one switch connection line (22), and that the circuit point of the power circuit connected to the ends of the parallel input branches remote from the base is connected, on the one hand, to the power transistor (501) and, on the other hand, via a diode (502) to a reference potential, and that a low- resistance measuring resistor (503) is provided between the connection of the diode (502) connected to reference potential and the switch connection line (22) connected to the emitter of the transistor (705) of the protection circuit (70).

17. Two-wire type switch as defined in any of claims 1 to 16, characterized in that the auxiliary impedance (502, 503) comprises a diode (502) connected, on the one hand, to the switching path of the power transistor (501) and, on the other hand, to a reference potential, a resistor (507) being connected in parallel with said diode.

18. Two-wire type switch as defined in any of claims 1 to 17, characterized in that the circuit component of the logic circuit (38) operating in accordance with an OR function is designed as a phase angle control (39) with two operational amplifiers (391, 392), each connected as a comparator and each comprising an input to which a reference voltage derived from the voltage (V) generated by the auxiliary voltage source (33) is applied, that a voltage proportional to the voltage (V) of said auxiliary voltage source (33) is applied to the second input of one operational amplifier (391), that a voltage derived from the voltage over the auxiliary impedance (502, 503, 507) is applied to the second input of the other operational amplifier (392), and that the outputs of said operational amplifiers (391, 392) are connected to an output (406) of said phase angle control (39).

19. Two-wire type switch as defined in claim 18, characterized in that a trigger circuit (405), if necessary with a negated output, is provided at the output (406) of the phase angle control (39).

20. Two-wire type switch as defined in claim 6, characterized in that said further transistor (337) is blockable by a blocking signal of said initiator (10).

## Revendications

1. Commutateur à deux conducteurs à transistor de puissance, en particulier un transistor MOS (30, 501) du type V ou vertical, monté en série avec une impédance d'appoint (32; 502, 503, 507) entre deux conducteurs de connexion du commutateur, aptes à être reliés aux pôles d'une source de courant continu pour produire une tension impulsionnelle continue entre zéro et une valeur maximum, avec un initiateur (10), en particulier sans contact, influençable de l'extérieur pour la production de signaux de verrouillage et de signaux d'amorçage pour le transistor, et avec une source de courant auxiliaire (33) pour la production d'une tension auxiliaire impulsionnelle ($V_0$) à la cadence de la tension impulsionnelle continue, caractérisé par le fait qu'un circuit logique (38) est prévu, qui présente un organe de commutation (40) opérant selon une fonction OU et qui présente une première entrée (a) et une deuxième entrée (b) et un organe de commutation (42) qui opère selon une fonction ET et qui présente deux entrées dont l'une est reliée à la sortie du premier organe de commutation (40) et dont l'autre forme une troisième entrée (c) du circuit logique (38), de telle manière que la première entrée (a) est reliée à la sortie de la source de courant auxiliaire (33), que la deuxième entrée (b) est reliée à un point de liaison commun du transistor de puissance (30) et de l'impédance d'appoint (32), et que la troisième entrée (c) est reliée à la sortie (18) de l'initiateur (10) et que le circuit logique (38) est constitué de telle façon que le transistor de puissance (30) est verrouillable à tout moment par un signal de blocage de l'initiateur (10) et qu'il est ensuite amorcé, par un signal d'amorçage de l'initiateur (10), pour le restant de l'impulsion de la tension impulsionnelle continue, lorsque la tension à la première ou à la deuxième entrée (a, respectivemetn b) du circuit logique (38) dépasse une valeur de seuil qui correspond à un "1" logique.

2. Commutateur à deux conducteurs suivant la revendication 1, caractérisé par le fait que la source de tension auxiliaire est constituée par un diviseur de tension (34, 36) disposé entre les conducteurs de connexion du commutateur (20, 22), et dont la prise est reliée à la première entrée (a) du circuit logique (38).

3. Commutateur à deux conducteurs suivant la revendication 1, caractérisé par le fait que la source de courant auxiliaire (33) est constituée par un régulateur de tension comportant un élément de stockage d'énergie électrique (344).

4. Commutateur à deux conducteurs suivant la revendication 3, caractérisé par le fait que la source de tension auxiliaire présente, du côté entrée, un transistor (334) dont une première borne de sa voie d'amorçage est reliée audit premier conducteur de connexion du commutateur (20), dont l'électrode de commande est reliée audit conducteur de connexion du commutateur (20) par l'intermédiaire d'une résistance (332) et, par l'intermédiaire d'une diode Zener (333), avec le potentiel de référence formé par l'autre conducteur de connexion (22) du commutateur et dont l'autre borne de la voie d'amorçage est reliée à la sortie (342) de la source de courant auxiliaire (33), par l'intermédiaire d'une résistance (340) et qui, en outre, est relié au potentiel de référence par un condensateur (344) servant de stockage d'élément d'énergie électrique, que parallèlement à la résistance (340) est prévu le montage série de la voie d'amorçage d'un second transistor (337) et d'une résistance (338) et que la base du second transistor (337) est relié au point de liaison commun des résistances (338, 340), par l'intermédiaire d'une résistance (336), ce point du circuit formant une seconde sortie (335) de la source de tension auxiliaire (33), auquel, en fonctionnement, une tension ($V_s$) est disponible, qui est supérieure à la tension ($V_0$) à la première sortie (342) de la source de tension auxiliaire (33).

5. Commutateur à deux conducteurs suivant la revendication 4, caractérisé par le fait que le transistor relié audit premier conducteur de connexion du commutateur (22) est un transistor MOS (334) du type V et par le fait que le second transistor est un transistor de Darlington (337).

6. Commutateur à deux conducteurs suivant la revendication 4 ou 5, caractérisé par le fait que la branche de la voie de l'amorçage de chaque transistor (334, 337) est montée une diode (331, 339) pour indiquer un état de court-circuit ou pour indiquer une fonction, que la seconde sortie (335) de la source de tension auxiliaire (333) est susceptible d'être reliée périodiquement au potentiel de référence, en fonction de la réponse d'un circuit de protection contre un court-circuit ou une surcharge (70), afin de faire passer un courant élevé par la voie d'amorçage du transistor (334) situé côté entrée et par la diode luminescente (331) qui est montée en série avec ce transistor, en sorte que celle-ci clignote, et que la base du second transistor (337) soit susceptible, en fonction de la réponse du circuit de protection contre un court-circuit ou une surcharge (70) de même qu'en fonction d'une réponse d'un circuit (60) servant à la suppression d'une impulsion de branchement, d'être portée à un potentiel de blocage, en sorte que la diode luminescente (339) servant à l'indication d'une fonction s'éteigne dans la branche de la voie d'amorçage de ce transistor (337) et que le courant soit bloqué pour le second transistor (337).

7. Commutateur à deux conducteurs suivant l'une des revendications 1 à 6, caractérisé par le fait qu'il est prévu un circuit (60) pour la suppression de l'impulsion de branchement grâce auquel, pour un temps de retard de préférence réglable, après le branchement de la source de tension continue (24), un signal de blocage est susceptible d'être produit, par lequel le transistor de puissance (501) peut être bloqué.

8. Commutateur à deux conducteurs suivant la revendication 7, caractérisé par le fait que le circuit (60) pour la suppression de l'impulsion de branchement présente un thyristor (606) qui, lors du branchement de la source de tension continue (24), est susceptible d'être commandé par l'intermédiaire de son électrode de commande et sans retard, dans son état passant pour produire un signal de blocage, ainsi qu'un autre commutateur à semi-conducteur commandable (601) qui est susceptible d'être actionné en fonction d'une tension de commande produite à l'aide d'un organe de temporisation (603, 604, 605), en partant de la tension de sortie (Vo) de la source de tension auxiliaire (33), pour produire un signal de blocage pour le thyristor.

9. Commutateur à deux conducteurs suivant la revendication 8, caractérisé par le fait que l'organe temporisateur (603, 604, 605) est formé d'une combinaison résistances/condensateurs.

10. Commutateur à deux conducteurs suivant la revendication 9, caractérisé par le fait qu'au moins une des résistances (603, 605) de la combinaison résistances/condensateurs (603, 604, 605) est constituée par une résistance réglable.

11. Commutateur à deux conducteurs suivant l'une des revendications 7 à 10, caractérisé par le fait que le signal de blocage du circuit (60) servant à la suppression de l'impulsion de branchement, est susceptible d'être appliqué à d'autres circuits (33, 70) pour le blocage de ceux-ci.

12. Commutateur à deux conducteurs suivant l'une des revendications 1 à 11, caractérisé par le fait qu'il est prévu un circuit (70) de protection vis-à-vis des court-circuits et vis-à-vis des surcharges, à l'aide duquel est susceptible d'être produit, au moins pour la durée d'un courte-circuit ou d'une surcharge, un signal de blocage à l'aide duquel le transistor de puissance (501) est susceptible d'être bloqué et à l'aide duquel, éventuellement d'autres circuits (33) peuvent être bloqués.

13. Commutateur à deux conducteurs suivant la revendication 12, caractérisé par le fait que le circuit de protection (70) pour la production du signal de blocage présente un commutateur électrique commandable (705) qui est susceptible d'être commandé sans retard par une branche d'entrée contenant une diode Zener (707) et, avec retard, par une seconde branche d'entrée contenant un organe temporisateur (708, 709, 710), en particulier un circuit RC (708, 709, 710), et que les deux branches d'entrée, montées en parallèle entre elles, sont reliées à un point du circuit de puissance qui comporte le transistor de puissance (501), auquel peut être prélevée une tension qui correspond au courant passant dans le transistor de puissance (501).

14. Commutateur à deux conducteurs suivant la revendication 12 ou 13, caractérisé par le fait qu'un circuit à accumulation d'énergie électrique (714) est prévu comme circuit de sortie du circuit de protection (70).

15. Commutateur à deux conducteurs suivant la revendication 14, caractérisé par le fait qu'à la sortie du circuit accumulateur d'énergie (714) est relié un multivibrateur instable à l'aide du signal de sortie duquel est susceptible d'être commandé une diode luminescente (331) servant à produire des signaux clignotant périodiques.

16. Commutateur à deux conducteurs suivant l'une des revendications 13 à 15, caractérisé par le fait qu'il est prévu, en tant que commutateur ou interrupteur électrique commandable (705) pour le circuit de protection (510), un transistor dont la base est reliée aux extrémités de la branche d'entrée parallèle, qui sont éloignées du circuit de puissance, et dont l'émetteur est relié directement avec le premier conducteur de branchement du commutateur (22), et que le point du circuit de puissance, qui est relié aux extrémités de la branche d'entrée parallèle, éloignée de la base, est relié, d'une part, au transistor de puissance (501), et, d'autre part, et par l'intermédiaire d'une diode (502), au potentiel de référence, et qu'entre la borne de la diode (502), qui est portée au potentiel de référence, et le conducteur de branchement du commutateur (22), qui est relié à l'émetteur du transistor (705) du circuit de protection (70), il est prévu une résistance de mesure faiblement ohmique (503).

17. Commutateur à deux conducteurs suivant l'une des revendications 1 à 16, caractérisé par le fait que l'impédance auxiliaire (502, 503) comporte une diode (502) qui est reliée, d'une part, à la voie d'amorçage du transistor de puissance (501), et, d'autre part, au potentiel de référence, une résistance (507) étant montée en parallèle sur la diode (502).

18. Commutateur à deux conducteurs suivant l'une des revendications 1 à 17, caractérisé par le fait que la partie du circuit logique (38), qui opère selon une fonction OU, est réalisé sous la forme d'une commande de découpage de phase (39), avec deux amplificateurs opérationnels (391, 392) qui sont montés respectivement en tant que comparateurs et comportent chacun une entrée à laquelle est appliquée une tension de référence qui est dérivée de la tension (V) qui est produite par la source de tension auxiliaire (33), qu'à la seconde entrée de l'un des amplificateurs opérationnels (391) est appliquée une tension qui est proportionnelle à la tension (V) dérivée de la source de tension auxiliaire (33), qu'à la seconde entrée de l'autre amplificateur opérationnel (392) est appliquée une tension qui est dérivée, par l'intermédiaire de l'impédance auxiliaire (502, 503, 507), de la tension, et que les sorties des amplificateurs opérationnels (391, 392) sont reliés à une sortie (406) du dispositif de commande de découpage de phase (39).

19. Commutateur à deux conducteurs suivant la revendications 18, caractérisé par le fait qu'à la sortie (406) du dispositif de commande à découpage de phase (39), il est prévu un circuit de déclenchement (405) présentant, éventuellement, une sortie de négation.

20. Commutateur à deux conducteurs suivant la revendication 6, caractérisé par le fait que ledit autre transistor (337) est susceptible d'être bloqué par un signal de blocage de l'initiateur (10).

# Fig.1

EP 0 219 074 B1

# Fig.2

**Fig.3**

Bildelemente / Bezeichnungen: 20, 22, 331, 332, 333, 334, 335, 336, 337, 338, 339, 340, 342, 344, 346, 348, 349, 350, 351, 352, 353; $V_s$, $V_o$, $AV_s$

33 Hilfsspannungsquelle

39 Phasen-anschnitt-steuerung

50 Treiber u. Schaltstufe

60 Einschalt-impuls-unter-drückung (610, 611, 612)

70 Kurzschl.- und Überlastschutz

10 Initiator

# Fig.4

# Fig.5

Phasenanschnitt – Steuerung 39

**Fig.6**

**Fig.7**

Fig.8